# EUROPEAN PATENT APPLICATION

(11) **EP 2 747 153 A2**
(43) Date of publication of application: **25.06.2014**
(21) Application number: 13005773.0
(22) Date of filing: 11.12.2013
(51) Int. Cl.: H01L 31/0687

(54) **Solar cell and method of manufacturing the same**

(30) Priority: 21.12.2012 KR 20120150835
(71) Applicant: LG Electronics, Inc., Seoul, 150-721 (KR)
(72) Inventor: Kim, Soohyun, 137-724 Seoul (KR); Lee, Heonmin, 137-724 Seoul (KR); Lee, Hyun, 137-724 Seoul (KR); Chung, Jinwon, 137-724 Seoul (KR)
(74) Representative: Frenkel, Matthias Alexander

(57) **Abstract**

A solar cell includes a first photoelectric conversion unit based on crystalline semiconductor, a second photoelectric conversion unit on the first photoelectric conversion unit and including a plurality of conversion portions based on amorphous semiconductor, a bonding layer disposed between the first and second photoelectric conversion units to connect the first photoelectric conversion unit to the second photoelectric conversion unit, and electrodes electrically connected respectively to the first and second photoelectric conversion units.

## Description

### CROSS-REFERENCE TO RELATED APPLICATION

This application claims the priority benefit of Korean Patent Application No.10-2012-0150835, filed on December 21, 2012, in the Korean Intellectual Property Office, the disclosure of which is incorporated herein by reference.

### BACKGROUND

### 1. Field

Embodiments relate to a solar cell and a method of manufacturing the same, and more particularly to a solar cell including various kinds of photoelectric conversion units and a method of manufacturing the same.

### 2. Description of the Related Art

Recently, as existing energy resources such as petroleum and coal are running out, interest in alternative energy sources is increasing. In particular, solar cells, which directly convert solar energy into electric energy, are receiving much attention as a next-generation alternative energy source.

These solar cells may be manufactured by forming various layers and electrodes. In this regard, efficiency of a solar cell may be determined according to the design of various layers and electrodes. For widespread use of solar cells, low efficiency thereof needs to be overcome. Therefore, there is a need to develop a method of manufacturing a solar cell having maximized efficiency through design of electrodes (i.e., area of electrodes) and various layers.

### SUMMARY

Embodiments provide a solar cell having maximized efficiency and a method of manufacturing the same.

In one embodiment, a solar cell includes a first photoelectric conversion unit based on crystalline semiconductor, a second photoelectric conversion unit on the first photoelectric conversion unit and including a plurality of conversion portions based on amorphous semiconductor, a bonding layer disposed between the first and second photoelectric conversion units to connect the first photoelectric conversion unit to the second photoelectric conversion unit, and electrodes electrically connected respectively to the first and second photoelectric conversion units.

In another embodiment, a method of manufacturing a solar cell includes forming a first photoelectric conversion unit by forming an emitter layer through doping of a semiconductor substrate including crystalline semiconductor with an impurity, forming a bonding layer on the emitter layer, forming a second photoelectric conversion unit including amorphous semiconductor on the bonding layer, and forming a first electrode electrically connected to the second photoelectric conversion unit and a second electrode electrically connected to the semiconductor substrate. The forming of the second photoelectric conversion unit may include forming a first conversion portion on the bonding layer, the first conversion portion having a first band gap that is higher than that of the semiconductor substrate, and forming a second conversion portion on the first conversion portion, the second conversion portion having a second band gap that is higher than the first band gap.

### BRIEF DESCRIPTION OF THE DRAWINGS

Details of the embodiments will be more clearly understood from the following detailed description taken in conjunction with the accompanying drawings, in which:
FIG. 1 is a partial sectional view of a solar cell according to an embodiment of the present invention;
FIG. 2 is a plan view illustrating a front surface of the solar cell of FIG. 1;
FIG. 3 is a circuit diagram of a solar cell including only a first photoelectric conversion unit that is based on crystalline silicon, according to an embodiment of the present invention;
FIG. 4 is a circuit diagram of a solar cell including a first photoelectric conversion unit that is based on crystalline silicon and a second photoelectric conversion unit that is based on amorphous silicon and includes a second conversion portion, according to an embodiment of the present invention;
FIG. 5 is a circuit diagram of a solar cell including a first photoelectric conversion unit that is based on crystalline silicon and a second photoelectric conversion unit that is based on amorphous silicon and includes first and second conversion portions, according to an embodiment of the present invention;
FIG. 6 is a graph showing a tendency of current density and quality according to thickness of an amorphous silicon thin film;
FIG. 7 is a partial sectional view of a solar cell according to another embodiment of the present invention;
FIG. 8 is a partial sectional view of a solar cell according to another embodiment of the present invention; and
FIG. 9 is a partial sectional view of a solar cell according to another embodiment of the present invention.

### DETAILED DESCRIPTION OF EMBODIMENTS

Reference will now be made in detail to embodiments, examples of which are illustrated in the accompanying drawings. However, the present disclosure may be embodied in many different forms and should not be construed as limited to the embodiments set forth herein.

Elements constituting features to describe the embodiments of the present invention are illustrated in the accompanying drawings and elements not necessary in describing the embodiments of the invention are omitted from the drawings, for clarity of description. Like reference numerals refer to like elements throughout. In the drawings, the widths, thicknesses, and etc., of constituent elements may be exaggerated or reduced for clarity and convenience of illustration. The present invention is not limited to the illustrated thicknesses, widths, and etc.

It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. In addition, in the description of the embodiments, it will be understood that when a layer (or film), a region, a pad, a pattern or a structure is referred to as being disposed 'on/above/over' another layer, region, pad, pattern, structure or substrate, it can be directly in contact with another layer, region, pad, pattern, structure or substrate, or one or more intervening layers, regions, pads, patterns or structures may also be present. In addition, it will also be understood that when a layer (or film), a region, a pad, a pattern or a structure are referred to as being disposed 'between' two layers, two regions, two pads, two patterns or two structures, only layer, region, pad, pattern or structure may be present between the two layers, the two regions, the two pads, the two patterns and the two structures or one or more intervening layers, regions, pads, patterns or structures may also be present.

Hereinafter, a solar cell and a method of manufacturing the same, according to embodiments of the present invention, will be described in detail with reference to the accompanying drawings.

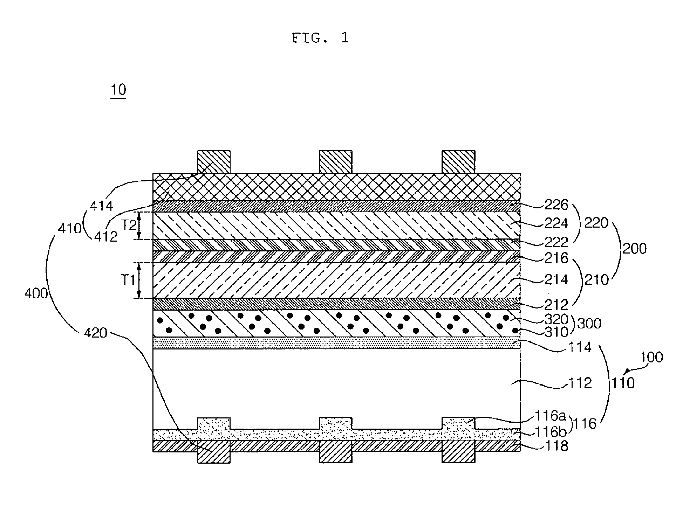

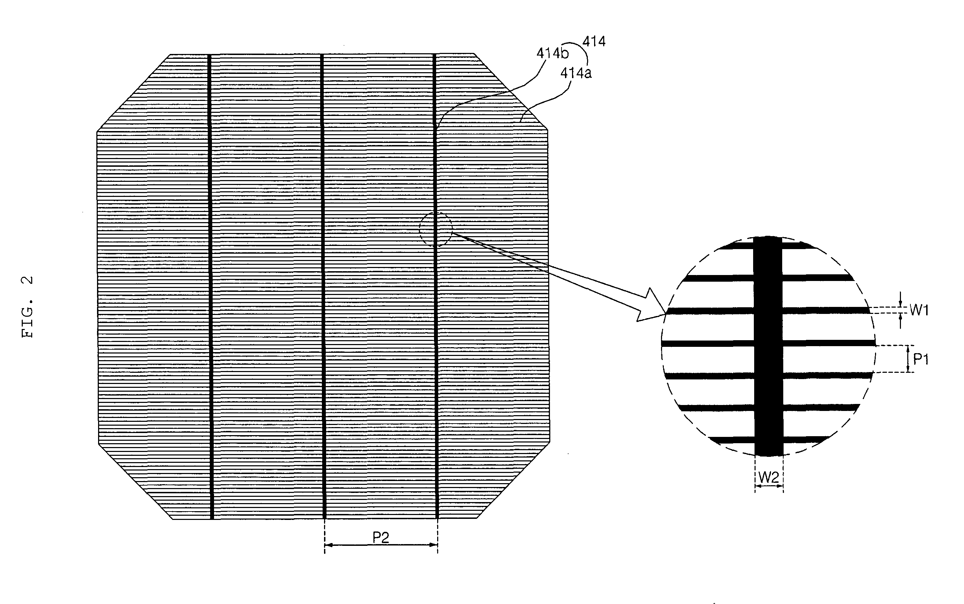

FIG. 1 is a partial sectional view of a solar cell 10 according to an embodiment of the present invention. FIG. 2 is a plan view illustrating a front surface of the solar cell 10 of FIG. 1.

Referring to FIG. 1, the solar cell 10 according to the present embodiment includes a first photoelectric conversion unit 100 based on crystalline semiconductor (e.g., crystalline silicon), a second photoelectric conversion unit 200 including a plurality of conversion portions 210 and 220 based on amorphous semiconductor (e.g., amorphous silicon), and a bonding layer 300 that adheres the first photoelectric conversion unit 100 to the second photoelectric conversion unit 200. In addition, the solar cell 10 includes an electrode 400 electrically connected to the first and second photoelectric conversion units 100 and 200 to collect generated charges. These elements will now be described in more detail.

The first photoelectric conversion unit 100 based on a crystalline semiconductor may include a pn junction or a crystalline semiconductor substrate 110 that forms a pn junction. More particularly, the semiconductor substrate 110 may be a wafer substrate. For example, the semiconductor substrate 110 may be a silicon wafer substrate made of monocrystalline silicon, polycrystalline silicon, or the like.

In this regard, the semiconductor substrate 110 may include a base region 112 of a first conductive type and an emitter layer 114 formed on a front surface of the base region 112 and having a second conductive type, thereby forming a pn junction. The base region 112 may be provided at a back surface thereof with a back surface field layer 116 that forms an electric field for preventing recombination between electrons and holes. The back surface field layer 116 may be the same type as that of the base region 112, i.e., a first conductive type and have a higher concentration than that of the base region 112.

In this regard, the emitter layer 114 may be formed by doping a front surface of the semiconductor substrate 110 with a second conductive type impurity using various methods such as ion implantation, thermal diffusion, or the like. The back surface field layer 116 may be formed by doping a back surface of the semiconductor substrate 110 with a first conductive type impurity using various methods such as ion implantation, thermal diffusion, or the like. A portion of the semiconductor substrate 110 in which the emitter layer 114 and the back surface field layer 116 are not formed forms the base region 112. In this case, the first photoelectric conversion unit 100 may be, as illustrated in FIG. 1, a homo-junction type photoelectric conversion unit.

In another embodiment, the emitter layer 114 (or a second conductive type impurity layer) may be formed on the semiconductor substrate 110 by deposition or the like and may be an amorphous or microcrystalline silicon layer including a second conductive type impurity. The back surface field layer 116 (or a first conductive type impurity layer) may be formed on the semiconductor substrate 110 by deposition or the like and may be an amorphous or microcrystalline silicon layer including a first conductive type impurity. In this case, the semiconductor substrate 110 entirely forms the base region 112, and the first photoelectric conversion unit 100 may be a hetero-junction type photoelectric conversion unit.

In an embodiment, the first conductive type may be an n-type and the second conductive type may be a p-type. As an n-type impurity, a Group V element such as phosphorus (P), arsenic (As), bismuth (Bi), antimony (Sb), or the like may be used. As a p-type impurity, a Group III element such as boron (B), aluminum (Al), gallium (Ga), indium (In), or the like may be used. The uppermost layer of the second photoelectric conversion unit 200 (e.g., a second upper layer 226) is a p-type conductive region and thus, light may be incident through the p-type layer. Accordingly, the solar cell 10 may have superior characteristics to that of a solar cell in which light is incident through an n-type conductive layer. However, the disclosure is not limited to the above example. That is, the first conductive type may be a p-type and the second conductive type may be an n-type.

Although not shown in the drawings, the front surface and/or back surface of the semiconductor substrate 110 may be provided with irregularities having a pyramid shape by a texturing process. When the semiconductor substrate 110 has increased surface roughness due to formation of irregularities at the front surface thereof, the reflectance of light incident through the front surface of the semiconductor substrate 110 may be reduced. Accordingly, it is possible to increase the amount of light reaching the pn junction formed at an interface between the base region 112 and the emitter layer 114 and thus, light loss may be minimized.

In the present embodiment, the emitter layer 114 may have a homogeneous emitter structure having an overall uniform doping concentration. For instance, the emitter layer 114 does not directly contact the electrode 400 and thus, the emitter layer 114 does not need to have a highly concentrated portion that is formed to reduce resistance at a contact surface between an emitter layer and an electrode. Accordingly, the emitter layer 114 may be realized as a shallow emitter. Consequently, the solar cell 10 may have increased current density.

In the present embodiment, the back surface field layer 116 may have first portions 116a having a high impurity concentration and a relatively low resistance and second portions 116b having a lower impurity concentration than that of the first portions 116a and a relatively high resistance. The first portions 116a are formed to partially or completely contact second electrodes 420, respectively.

As such, in the present embodiment, each of the second portions 116b having a relatively high resistance may be formed in a region between the second electrodes 420, whereby recombination between holes and electrons may be prevented. Accordingly, the solar cell 10 may have increased current density. In addition, the first portions 116a having a relatively low resistance may be respectively formed in regions adjacent to the respective second electrodes 420, whereby contact resistance thereof with the second electrodes 420 may be reduced. That is, the back surface field layer 116 according to the present embodiment may have a selective back surface field structure, whereby the solar cell 10 may have maximized efficiency.

However, the disclosure is not limited to the above example, and the back surface field layer 116 may have a homogeneous back surface field structure having a uniform doping concentration. Alternatively, the back surface field layer 116 may have a local back surface field structure in which the back surface field layer 116 is locally formed at only portions of the back surface of the semiconductor substrate 110 which adjoin the second electrodes 420.

A passivation film 118 may be formed on substantially the entire back surface of the semiconductor substrate 110 except for portions in which the second electrodes 420 are formed. The passivation film 118 may inactivate defects present in the back surface of the semiconductor substrate 110, thereby removing recombination sites of minority carriers. Accordingly, an open-circuit voltage of the solar cell 10 may be increased.

The passivation film 118 may be made of a transparent insulating material, to allow light to pass therethrough. Accordingly, light can be incident upon the back surface of the semiconductor substrate 110 through the passivation film 118 and, as such, the efficiency of the solar cell 10 may be enhanced. For example, the passivation film 118 may have a single-layer structure of any one film selected from the group consisting of a silicon nitride film, a silicon nitride film containing hydrogen, a silicon oxide film, a silicon oxide nitride film, an MgF₂ film, a ZnS film, a TiO₂ film, and a CeO₂ film, or a multi-layered structure of at least two of these films. However, the disclosure is not limited to the above examples, and the passivation film 118 may include various materials.

The first photoelectric conversion unit 100 including the semiconductor substrate 110 may have a band gap of 1.0 eV to 1.2 eV. However, the disclosure is not limited to the above example, and the band gap of the first photoelectric conversion unit 100 may vary according to constituent materials of the semiconductor substrate 110.

The semiconductor substrate 110 is provided on the front surface of the semiconductor substrate 110 (more particularly, the emitter layer 114) with the bonding layer 300 to connect the first photoelectric conversion unit 100 to the second photoelectric conversion unit 200. FIG. 1 illustrates that the bonding layer 300 directly contacts the emitter layer 114 and the second photoelectric conversion unit 200, but the disclosure is not limited thereto.

The bonding layer 300 may include a material having excellent electrical conductivity and connect the first and second photoelectric conversion units 100 and 200 so as to have excellent electrical properties. In addition, the bonding layer 300 has reflection properties and thus, when light incident through the front surface of the solar cell 10 reaches the bonding layer 300, the light is partially reflected towards the second photoelectric conversion unit 200 and the remaining light proceeds towards the first photoelectric conversion unit 100. The light reflected towards the second photoelectric conversion unit 200 is absorbed by the solar cell 10 by total reflection occurring at an interface between a transparent electrode layer 412 of a first electrode 410 and air. Accordingly, light can repetitively move between the front surface of the solar cell 10 and the bonding layer 300. This configuration is intended to increase the amount of light absorbed by the second photoelectric conversion unit 200 having a relatively long absorption wavelength by considering that absorption coefficient decreases as absorption wavelength increases.

For example, the bonding layer 300 may be formed such that micro-crystalline semiconductor 310 doped with a first conductive type material are included in an amorphous matrix 320.

In this regard, the amorphous matrix 320 may be made of amorphous silicon oxide or amorphous silicon carbide. Since the amorphous matrix 320 is formed of a silicon-based material and thus, has similar properties to those of the first and second photoelectric conversion units 100 and 200, the bonding layer 300 may have excellent bonding properties. In addition, the amorphous matrix 320 may further include carbon or oxygen capable of reducing index of refraction and thus, reflection properties of the bonding layer 300 may be satisfactorily controlled. The bonding layer 300 including carbon or oxygen may have an index of refraction of 1.6 to 1.9, which is relatively low. However, the disclosure is not limited to the above example, and the index of refraction of the bonding layer 300 may be variously changed.

The micro-crystalline semiconductor 310 are formed to enhance electrical properties, and may be, for example, silicon micro-crystals. That is, the micro-crystalline semiconductor 310 enable smooth flow of charges by tunneling. A volume fraction of the micro-crystalline semiconductor 310 in the bonding layer 300 may be 5% to 30%. When the volume fraction of the micro-crystalline semiconductor 310 is less than 5%, effects of improving electrical properties may be insignificant. On the other hand, when the volume fraction of the micro-crystalline semiconductor 310 is greater than 30%, it may be difficult to prepare the bonding layer 310.

The bonding layer 300 may have a thickness of 50 nm to 200 nm. When the thickness of the bonding layer 300 is greater than 200 nm, raw material costs and manufacturing time may be increased. When the thickness of the bonding layer 300 is less than 50 nm, effects by the bonding layer 300 may be insufficient.

The bonding layer 300 may be formed using various methods. For example, the bonding layer 300 may be formed by deposition or the like. Precipitation of the micro-crystalline semiconductor 310 in the amorphous matrix 320 may be performed using various methods. For example, the micro-crystalline semiconductor 310 may be precipitated by chemical vapor deposition (CVD) under optimized manufacturing conditions for formation of an amorphous silicon layer (e.g., electric power, pressure, a mixing ratio of raw material gases).

A method of forming the bonding layer 300 by CVD will now be described in more detail. A voltage may be applied to an electrode while introducing silane gas (SiH₄), carbon dioxide gas (CO₂), and hydrogen gas (H₂) into a chamber maintained in a vacuum state so that the micro-crystalline semiconductor 310 based on silicon may be formed on the amorphous matrix 320 composed of amorphous silicon oxide. In this regard, a gas containing a conductive type impurity (e.g., PH₃, B₂H₆) may be introduced along with the above-described gases so that the bonding layer 300 has a desired conductive type.

The silane gas and carbon dioxide gas are used to respectively supply silicon and oxygen that constitute silicon oxide, but the disclosure is not limited thereto. That is, various other gases for supply of silicon and oxygen may be used. For example, as a gas for supply of oxygen, oxygen (O₂) gas, nitrogen oxide (N₂O) gas, carbon monoxide (CO) gas, or the like may be used. Hydrogen gas relieves defects such as dangling bonds in the bonding layer 300 and also enables formation of the micro-crystalline semiconductor 310 and adjustment of an index of refraction. More particularly, as the amount of hydrogen gas increases, generation of the micro-crystalline semiconductor 310 may be accelerated. In addition, as the amount of the micro-crystalline semiconductor 310 increases, the index of refraction of the bonding layer 300 increases.

In this regard, an electric power of about 0.1 to 0.3 W/cm² may be used in the CVD process. When the electric power exceeds 0.3 W/cm², defects of the prepared bonding layer 300 may increase. On the other hand, when the electric power is less than 0.1 W/cm², the microcrystalline semiconductor 310 may be insufficiently formed.

A ratio of hydrogen gas to silane gas (H₂/SiH₄) may be 100:1 to 350:1. When the ratio of H₂/SiH₄ is greater than 350:1, deposition rate may be reduced. On the other hand, when the ratio of H₂/SiH₄ is less than 100:1, the micro-crystalline semiconductor 310 may be insufficiently formed.

A ratio of carbon dioxide gas to silane gas (CO₂/SiH₄) may be 2:1 or more, more particularly, 2:1 to 5:1. When the ratio of CO₂/SiH₄ is less than 2:1, obtaining a desired index of refraction of the bonding layer 300 is difficult. On the other hand, when the ratio of CO₂/SiH₄ is greater than 5:1, the micro-crystalline semiconductor 310 may be insufficiently formed.

However, the above-described numerical ranges are provided for illustrative purposes only, and the disclosure is not limited thereto. That is, when the kinds of raw material gases and electric power to be supplied are varied or the index of refraction and constituents required for the bonding layer 300 are changed, the above-described numerical ranges may be variously changed.

In the present embodiment, the second photoelectric conversion unit 200 based on amorphous semiconductor (e.g., amorphous silicon) may be disposed on the bonding layer 300. In this regard, the second photoelectric conversion unit 200 includes a plurality of conversion portions 210 and 220 having different band gaps. In the present embodiment, the conversion portions 210 and 220 include a first conversion portion 210 and a second conversion portion 220 that are sequentially disposed on the bonding layer 300. The first conversion portion 210 may include a first lower layer 212, a first intrinsic layer 214, and a first upper layer 216 that are sequentially formed on the bonding layer 300, and the second conversion portion 220 may include a second lower layer 222, a second intrinsic layer 224, and a second upper layer 226 that are sequentially formed on the first conversion portion 210.

Due to such configuration, the first and second intrinsic layers 214 and 224 have thicknesses (e.g., 500 nm or less) that do not deteriorate thin film quality and also enable balance among current densities of the first and second intrinsic layers 214 and 224 and the first photoelectric conversion unit 100. Lower limits of the thicknesses of the first and second intrinsic layers 214 and 224 are not limited, but the first and second intrinsic layers 214 and 224 may each have a thickness of at least 5 nm (more particularly, 50 nm) so as to sufficiently absorb light. For example, a ratio of a current density of the first conversion portion 210 to a current density of the first photoelectric conversion unit 100 may be 0.8:1 to 1.2:1, and a ratio of a current density of the second conversion portion 220 to a current density of the first photoelectric conversion unit 100 may be 0.8:1 to 1.2:1. In this regard, the ratio of 0.8:1 to 1.2:1 is provided based on determination that balance among the current densities thereof is formed, but the disclosure is not limited thereto. Thus, a determination basis on balance among the current densities of the above-described elements may vary according to cases. In the present embodiment, the efficiency of the solar cell 10 may be maximized by balance between current densities and the thicknesses of the first and second intrinsic layers 214 and 224. This will be described below in more detail.

The first lower layer 212 of the first conversion portion 210 may be formed of microcrystalline silicon or amorphous silicon including a first conductive type impurity. That is, the first lower layer 212 includes the same conductive type impurity as that of the base region 112 and the bonding layer 300. For example, the first lower layer 212 may include an n-type impurity, but the disclosure is not limited thereto. Thus, when the base region 112 and the bonding layer 300 are of a p-type, the first lower layer 212 may include a p-type impurity.

The first lower layer 212 may have a thickness of 5 to 40 nm (e.g., 10 to 30 nm). This range is limited to a thickness appropriate to form a pin junction structure by the first intrinsic layer 214 and the second upper layer 216, but the disclosure is not limited thereto. Thus, the first lower layer 212 may have various thicknesses.

The first intrinsic layer 214 is directly involved in photoelectric conversion, and the current density of the first conversion portion 210 varies according to the band gap and thickness of the first intrinsic layer 214.

The first intrinsic layer 214 has a higher band gap than that of crystalline silicon of the first photoelectric conversion unit 100 and a lower band gap than that of the second intrinsic layer 224. For example, the first intrinsic layer 214 of the first conversion portion 210 may have a band gap of 1.2 eV to 1.6 ev (e.g., 1.3 eV to 1.5 eV). To have a lower band gap than that of the second conversion portion 220, the first intrinsic layer 214 may include an element (e.g., germanium) capable of reducing the band gap. For example, an atomic percent of germanium in the first intrinsic layer 214 may be 15% to 40%. The atomic percent of germanium is limited such that the first intrinsic layer 214 has a band gap of 1.2 eV to 1.6 ev (e.g., 1.3 eV to 1.5 eV).

The first intrinsic layer 214 may have a thickness T1 that enables balance current densities of the first photoelectric conversion unit 100 and the second intrinsic layer 224 by considering the band gaps and thicknesses of the first photoelectric conversion unit 100 and the second intrinsic layer 224 and does not reduce thin film quality. In this regard, the thickness T1 of the first intrinsic layer 214 may be larger than a thickness T2 of the second intrinsic layer 224. That is, taking into consideration the fact that the first intrinsic layer 214 has a lower band gap than that of the second intrinsic layer 224, the thickness T1 of the first intrinsic layer 214 is larger than that of the second intrinsic layer 224, thereby balancing the current densities. For example, the first intrinsic layer 214 of the first conversion portion 210 may have a thickness T1 of 100 nm to 350 nm (e.g., 150 to 300 nm).

The first upper layer 216 may be formed of amorphous silicon including a second conductive type impurity. That is, the first upper layer 216 includes the same conductive type impurity as that of the emitter layer 114. For example, the first upper layer 216 may include a p-type impurity. However, the disclosure is not limited to the above example. Thus, when the emitter layer 114 is of an n-type, the first upper layer 216 may include an n-type impurity.

In this regard, the amorphous silicon of the first upper layer 216 may include carbon or oxygen. Due to inclusion of carbon, oxygen, or the like, band gap may gradually increase towards the second intrinsic layer 224 from the first intrinsic layer 214.

The first upper layer 216 may have a thickness of 5 to 30 nm (e.g., 10 to 20 nm). The thickness of the first upper layer 216 is limited to such range appropriate for formation of a pin or nip junction structure by the first lower layer 212 and the first intrinsic layer 214, but the disclosure is not limited thereto. Thus, the first upper layer 216 may have various thicknesses.

The second lower layer 222 of the second conversion portion 220 may be formed of microcrystalline silicon or amorphous silicon including a first conductive type impurity. That is, the second lower layer 222 includes the same conductive type impurity as that of the base region 112 and the bonding layer 300. For example, the second lower layer 222 may include an n-type impurity, but the disclosure is not limited thereto. Thus, when the base region 112 and the bonding layer 300 are of a p-type, the second lower layer 222 may include a p-type impurity.

The second lower layer 222 may have a thickness of 5 to 40 nm (e.g., 10 to 30 nm). This range is limited to a thickness appropriate to form a pin or nip junction structure by the second intrinsic layer 224 and the second upper layer 216, but the disclosure is not limited thereto. Thus, the second lower layer 212 may have various thicknesses.

The second intrinsic layer 224 is directly involved in photoelectric conversion, and the current density of the second conversion portion 220 varies according to the band gap and thickness of the second intrinsic layer 224.

The second intrinsic layer 224 has a higher band gap than that of crystalline silicon of the first photoelectric conversion unit 100 and that of the first intrinsic layer 214. For example, the second intrinsic layer 224 of the second conversion portion 220 may have a band gap of 1.6 eV to 1.9 ev (e.g., 1.6 eV to 1.8 eV). To have a relatively high band gap, the second intrinsic layer 224 may not be doped with a separate impurity (e.g., germanium).

The second intrinsic layer 224 may have a thickness T2 that enables balance current densities of the first intrinsic layer 214 and the first photoelectric conversion unit 100 by considering the band gaps and thicknesses of the first photoelectric conversion unit 100 and the first intrinsic layer 214 and does not reduce thin film quality. In this regard, as described above, the thickness T2 of the second intrinsic layer 224 may be smaller than the thickness T1 of the first intrinsic layer 214. For example, the thickness T2 of the second intrinsic layer 224 of the second conversion portion 220 may be 50 nm to 300 nm (e.g., 100 to 250 nm, for example, 100 to 150 nm).

The second upper layer 226 may be formed of amorphous silicon including a second conductive type impurity. That is, the second upper layer 226 includes the same conductive type impurity as that of the emitter layer 114. For example, the second upper layer 226 may include a p-type impurity. However, the disclosure is not limited to the above example. Thus, when the emitter layer 114 is of an n-type, the second upper layer 226 may include an n-type impurity.

In this regard, the amorphous silicon of the second upper layer 226 may include carbon or oxygen. Due to inclusion of carbon, oxygen, or the like, band gap may increase towards the second upper layer 226 from the second intrinsic layer 224.

The second upper layer 226 may have a thickness of 5 to 30 nm (e.g., 10 to 20 nm). This range is limited to a thickness appropriate to form a pin or nip junction structure by the second lower layer 222 and the second intrinsic layer 224, but the disclosure is not limited thereto. Thus, the second upper layer 226 may have various thicknesses.

Each layer of the first and second conversion portions 210 and 220 may be formed using various methods, for example, deposition.

The first electrode 410 that is electrically connected to the second photoelectric conversion unit 200 and collects charges is disposed on the second photoelectric conversion unit 200. In the present embodiment, the first electrode 410 includes the transparent electrode layer 412 formed on the second photoelectric conversion unit 200 and metal electrodes 414 formed on the transparent electrode layer 412 to enhance electrical conductivity.

The transparent electrode layer 412 may be entirely formed on the second photoelectric conversion unit 200. The transparent electrode layer 412 may include a conductive oxide, such as indium oxide and zinc oxide. The transparent electrode layer 412 may have a thickness of 100 nm to 300 nm. When the thickness of the transparent electrode layer 412 is less than 100 nm, the transparent electrode layer 412 may have poor electrical properties. On the other hand, when the thickness of the transparent electrode layer 412 exceeds 300 nm, the transparent electrode layer 412 may have low transmittance. However, the disclosure is not limited to the above example, and the transparent electrode layer 412 may have various thicknesses.

The metal electrodes 414 are formed on the transparent electrode layer 412 so as to form a pattern. The metal electrodes 414 have excellent electrical conductivity and thus, reduce resistance. The metal electrodes 414 may include a metal with low resistance and excellent electrical conductivity, for example, copper, silver, gold, platinum, or the like. In the present embodiment, a surface of the transparent electrode layer 412 on which the metal electrodes 414 are disposed corresponds to a front surface and thus, a large amount of light is incident thereupon. Therefore, the metal electrodes 414 may have a shape that does not interfere with incidence of light.

For example, referring to FIG. 2, each metal electrode 414 may include a plurality of finger electrodes 414a having a first pitch P1 and arranged in parallel. In addition, the metal electrode 414 may include bus bar electrodes 414b formed in a direction crossing the finger electrodes 414a to connect the finger electrodes 414a to one another. In this regard, a single bus bar electrode 414b may be formed, or, as illustrated in FIG. 2, a plurality of bus bar electrodes 414b having a second pitch P2 that is greater than the first pitch P1 may be formed. In this regard, the finger electrode 414a may have a width W1 that is smaller than a width W2 of the bus bar electrode 414b, but the disclosure is not limited thereto. For example, the width W1 of the finger electrode 414a may be the same as the width W2 of the bus bar electrode 414b. The shape of the metal electrodes 414 is provided for illustrative purposes only, and should not be construed as limiting the scope of the embodiment.

The transparent electrode layer 412 may be formed by deposition, sputtering, or the like, and the metal electrodes 414 may be formed by deposition, sputtering, plating, printing, or the like.

The semiconductor substrate 110 is provided on the rear surface thereof with the second electrodes 420 connected to the back surface field layer 116. Similar to the first electrode 410, the second electrode 420 may include finger electrodes and bus bar electrodes so that light may be incident upon the back surface of the semiconductor substrate 110. In this regard, the solar cell 10 is configured as a bi-facial solar cell. The second electrode 420 may be formed by deposition, sputtering, plating, printing, or the like.

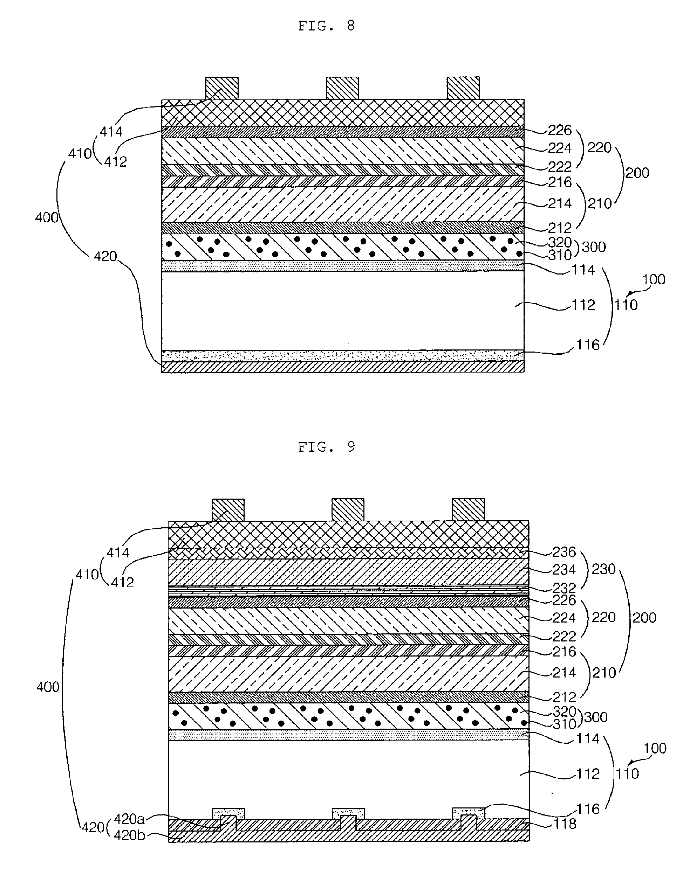

However, the shape of the second electrode 420 is not limited to the above example. Another example of the second electrode 420 will be described below in more detail with reference to FIG. 8.

In the present embodiment, the first photoelectric conversion unit 100 that is based on crystalline silicon is bonded to the second photoelectric conversion unit 200 that is based on amorphous silicon by the bonding layer 300. In this regard, the second photoelectric conversion unit 200 that is based on amorphous silicon has a higher band gap than that of the first photoelectric conversion unit 100 that is based on crystalline silicon. Accordingly, the first photoelectric conversion unit 100 has a relatively low band gap and thus, may effectively absorb a long wavelength, and the second photoelectric conversion unit 200 has a relatively high band gap and thus, may absorb a short or middle wavelength. In addition, the second photoelectric conversion unit 200 includes the first and second conversion portions 210 and 220 that have different band gaps and thus, current densities of the first and second photoelectric conversion units 100 and 200 may be maintained at a uniform level.

More particularly, when light is incident through the front surface of the semiconductor substrate 10, the second conversion portion 220 absorbs a long wavelength to generate electrons and holes by photoelectric conversion. In this regard, the holes move toward the first electrode 410 to be collected, and the electrons move toward the second electrodes 420 via the first conversion portion 210 and the first photoelectric conversion unit 100 to be collected.

The first conversion portion 210 absorbs a middle wavelength of light among light beams having passed through the second conversion portion 220 to generate electrons and holes by photoelectric conversion. In this regard, the holes move toward the first electrode 410 via the second conversion portion 220 to be collected, and the electrons move toward the second electrodes 420 via the first photoelectric conversion unit 100 to be collected.

The first photoelectric conversion unit 100 absorbs a short wavelength of light among light beams having passed through the second photoelectric conversion unit 200 to generate electrons and holes by photoelectric conversion. In this regard, the holes move toward the first electrode 410 via the second photoelectric conversion unit 200 to be collected, and the electrons move toward the second electrodes 420 to be collected.

As described above, in the present embodiment, light of various wavelengths may be used and thus, efficiency loss that occurs due to non-use of some of the wavelengths may be prevented. Efficiency loss that occurs due to non-use of a particular range of wavelengths corresponds to 50% or more of a total efficiency loss. In the present embodiment, such efficiency loss may be prevented, whereby the efficiency of the solar cell 10 may be significantly enhanced.

In addition, the second photoelectric conversion unit 200 includes the first and second conversion portions 210 and 220 and thus, may maintain a similar current density to that of the first photoelectric conversion unit 100 and also prevent the thicknesses of the first and second conversion portions 210 and 220 from being excessively increased. For example, the first and second conversion portions 210 and 220 (particularly, first and second intrinsic layers 214 and 224) each have a thickness of 500 nm or less. When the thickness of each of the first and second conversion portions 210 and 220 exceeds 500 nm, quality of a thin film of amorphous silicon may be deteriorated.

In this regard, the thickness of the first intrinsic layer 214 of the first conversion portion 210 is formed larger than that of the second intrinsic layer 224 of the second conversion portion 220 by considering the band gaps of the first and second conversion portions 210 and 220. Accordingly, the current densities of the first photoelectric conversion unit 100 and the first and second conversion portions 210 and 220 may be maintained at a similar level. This will be described below in more detail together with particular values.

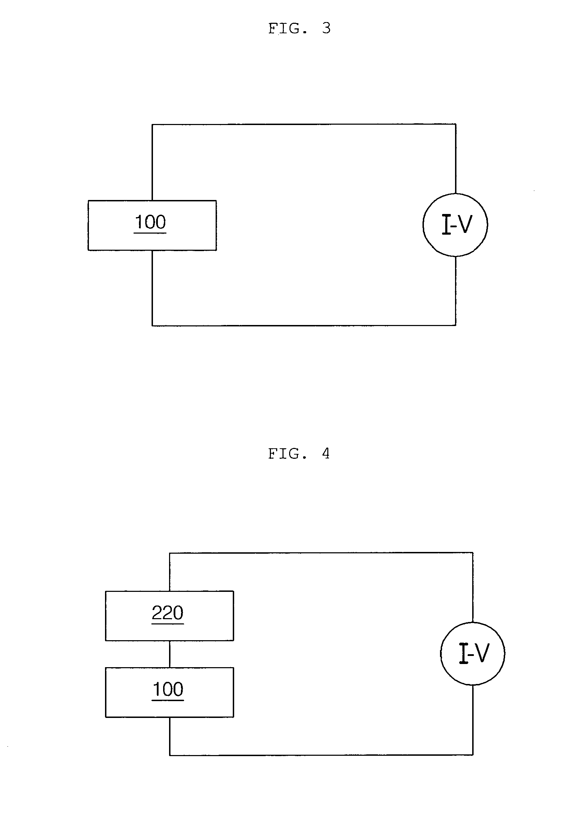

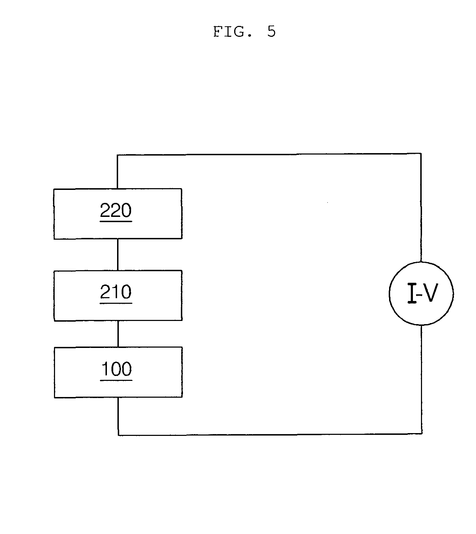

FIG. 3 is a circuit diagram of a solar cell including only the first photoelectric conversion unit 100 that is based on crystalline silicon, according to an embodiment of the present invention. FIG. 4 is a circuit diagram of a solar cell including the first photoelectric conversion unit 100 that is based on crystalline silicon and the second photoelectric conversion unit 200 that is based on amorphous silicon and includes the second conversion portion 220, according to an embodiment of the present invention. FIG. 5 is a circuit diagram of a solar cell including the first photoelectric conversion unit 100 that is based on crystalline silicon and the second photoelectric conversion unit 200 that is based on amorphous silicon and includes the first and second conversion portions 210 and 220, according to an embodiment of the present invention. In this regard, it is assumed that total current density is 38 mV/cm² and a packing factor is 1. In addition, it is assumed that a band gap of the first photoelectric conversion unit 100 is 1.1 eV, an open-circuit voltage thereof is 0.6 V, a band gap of the first conversion portion 210 is 1.4 eV, an open-circuit voltage thereof is 0.8 V, and a band gap of the second conversion portion 220 is 1.7 eV, and an open-circuit voltage thereof is 1 V. In the embodiments illustrated in FIGS. 4 and 5, the thickness of the second conversion portion 220 is the same, i.e., 500 nm or less.

Referring to FIG. 3, the solar cell 10 including only the first photoelectric conversion unit 100 has a current density of 38 mV and an open-circuit voltage of 0.6 eV, and thus, the efficiency of the solar cell 10 is 22.8%, which is obtained by multiplying the current density (38mV/cm²) by the open-circuit voltage (0.6 V) by the packing factor of 1.

Referring to FIG. 4, the solar cell 10 including the first photoelectric conversion unit 100 and the second conversion portion 220 has an open-circuit voltage of 1.6 V which is obtained by adding the open-circuit voltage of the first photoelectric conversion unit 100, i.e., 0.6 V, and the open-circuit voltage of the second conversion portion 220, i.e., 1.0 V. In addition, the first photoelectric conversion unit 100 has a current density of 26 mA/cm² and the second conversion portion 220 has a current density of 12 mA/cm². In this regard, total current density is 12 mA/cm², which is the lower one of the two current densities. Thus, the efficiency of the solar cell 10 is 19.2%, obtained by multiplying the current density (12 mV/cm²) by the open-circuit voltage (1.6 V) by the packing factor of 1. In this case, even through the solar cell 10 further includes the second conversion portion 220, the efficiency thereof is rather decreased. Such phenomenon occurs because the current density of the second conversion portion 220 that is disadvantageous in generation of current due to current imbalance is used as total current density.

That is, in the solar cell 10 including the first photoelectric conversion unit 100 that is based on crystalline silicon and the second conversion portion 220 that is based on amorphous silicon, the current density of the second conversion portion 220 that has a low current density due to disadvantage in current generation is used as total current density of the solar cell. Thus, even though open-circuit voltage increases, current density is considerably decreased and thus, overall efficiency of the solar cell is substantially reduced.

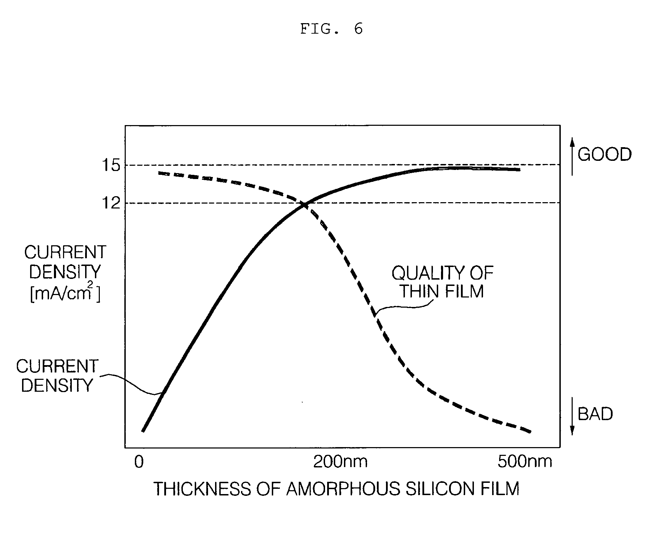

To balance current densities, first, problems occurring in a case in which the second conversion portion 220 is formed to a thickness that exceeds 500 nm will be described with reference to FIG. 6. FIG. 6 is a graph showing a tendency of current density and quality according to thickness of an amorphous silicon thin film. Referring to FIG. 6, when the thickness of the amorphous silicon thin film exceeds 500 nm, the current density no longer increases and the quality of the amorphous silicon thin film is severely reduced. Film quality is related to packing factor, and thus, when the thickness of the amorphous silicon thin film exceeds 500 nm, effects of increasing current density are not obtained and only packing factor is reduced. Thus, to balance current, the thickness of the amorphous silicon thin film should be 500 nm or less. When the thickness of the amorphous silicon thin film exceeds 500 nm, the efficiency of the solar cell is substantially decreased.

As illustrated in FIG. 6, when the solar cell includes the first photoelectric conversion unit 100 and the second photoelectric conversion unit 200 including the first and second conversion portions 210 and 220, the solar cell has an open-circuit voltage of 2.4 V which is obtained by adding the open-circuit voltage of the first photoelectric conversion unit 100, i.e., 0.6 V, the open-circuit voltage of the first conversion portion 210, i.e., 0.8 V, and the open-circuit voltage of the second conversion portion 220, i.e., 1.0 V. In addition, the first photoelectric conversion unit 100 has a current density of 14 mA/cm², the first conversion portion 210 has a current density of 12 mA/cm², and the second conversion portion 220 has a current density of 12 mA/cm². These current densities are obtained by adjusting the band gaps and thicknesses of the first and second intrinsic layers 214 and 224. In this regard, total current density is 12 mA/cm², which is the lowest current density among the above-listed current densities. Thus, the efficiency of the solar cell 10 is 28.8% as obtained by multiplying the current density (12 mV/cm²) by the open-circuit voltage (2.4 V) by the packing factor of 1. From this result, it can be confirmed that the efficiency of the solar cell 10 may be significantly improved as compared to the two previous cases.

Hereinafter, a method of manufacturing the solar cell 10 will be described in detail. The emitter layer 114 and/or the back surface field layer 116 are formed at the semiconductor substrate 110 including crystalline semiconductor by doping to form the first photoelectric conversion unit 100. The bonding layer 300 is formed on the emitter layer 114. The second photoelectric conversion unit 200 including amorphous semiconductor is formed on the bonding layer 300. Thereafter, the first electrode 410 connected to the second photoelectric conversion unit 200 and the second electrodes 420 connected to the semiconductor substrate 110 are formed. Formation of the first and second electrodes 410 and 420 may be performed using different processes according to embodiments. The second electrodes 420 may be formed before formation of the bonding layer 300.

Hereinafter, a solar cell according to another embodiment of the present invention and a method of manufacturing the same will be described in detail. In the following description, a detailed description of identical or almost identical elements as those described in previous embodiments is omitted and elements different from those in the above-described embodiments will be described in detail.

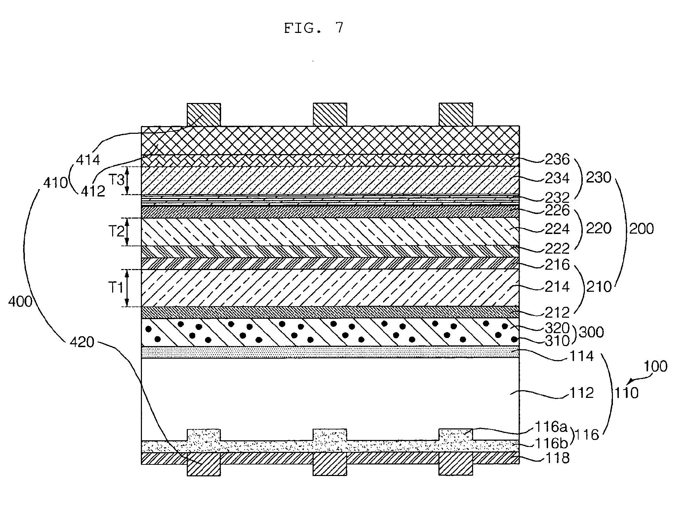

FIG. 7 is a partial sectional view of a solar cell according to another embodiment of the present invention.

Referring to FIG. 7, the second photoelectric conversion unit 200 includes the first conversion portion 210, a second conversion portion 220, and a third conversion portion 230. Accordingly, a difference among band gaps of the first, second and third conversion portions 210, 220 and 230 is smaller than in the embodiment illustrated in FIG. 1 and thus, a larger number of wavelengths of light may be used and current densities of these elements may be more balanced.

The first conversion portion 210 includes the first lower layer 212, the first intrinsic layer 214, and the first upper layer 216 that are sequentially formed on the bonding layer 300. The second conversion portion 220 includes the second lower layer 222, the second intrinsic layer 224, and the second upper layer 226 that are sequentially formed on the first conversion portion 210. The third conversion portion 230 includes a third lower layer 232, a third intrinsic layer 234, and a third upper layer 236 that are sequentially formed on the second conversion portion 220.

The first lower layer 212 may be formed of microcrystalline silicon or amorphous silicon which includes a first conductive type impurity. The first lower layer 212 may have a thickness of 5 to 40 nm (e.g., 10 to 30 nm).

The first intrinsic layer 214 has a higher band gap than that of crystalline silicon of the first photoelectric conversion unit 100 and a lower band gap than that of the second and third intrinsic layers 224 and 234 of the respective second and third conversion portions 220 and 230. For example, the first intrinsic layer 214 may have a band gap of 1.2 eV to 1.45 eV (e.g., 1.25 eV to 1.35 eV). To suit the band gap, an atomic percent of germanium in the first intrinsic layer 214 may be 25% to 50%. The atomic percent range is limited such that the first intrinsic layer 214 has the above-described band gap. The first intrinsic layer 214 may have a thickness T1 of 100 nm to 350 nm (e.g., 150 nm to 300 nm).

The first upper layer 216 may be formed of amorphous silicon including a second conductive type impurity. In this regard, the amorphous silicon of the first upper layer 216 may include carbon or oxygen. The first upper layer 216 may have a thickness of 5 to 30 nm (e.g., 10 to 25 nm).

The second lower layer 222 may be formed of microcrystalline silicon or amorphous silicon which includes a first conductive type impurity. The second lower layer 222 may have a thickness of 5 to 40 nm (e.g., 10 to 30 nm).

The second intrinsic layer 224 has a higher band gap than that of each of the first photoelectric conversion unit 100 and the first intrinsic layer 214 and a lower band gap than that of the third intrinsic layer 234. For example, the second intrinsic layer 224 may have a band gap of 1.4 eV to 1.6 eV. To suit the band gap, an atomic percent of germanium in the second intrinsic layer 224 may be 10% to 35%. The atomic percent range is limited such that the second intrinsic layer 224 has the above-described band gap. The second intrinsic layer 224 may have a thickness T2 of 50 nm to 300 nm (e.g., 100 nm to 250 nm).

The second upper layer 226 may be formed of amorphous silicon including a second conductive type impurity. In this regard, the amorphous silicon of the second upper layer 226 may include carbon or oxygen. The second upper layer 226 may have a thickness of 5 to 30 nm (e.g., 10 to 20 nm).

The third lower layer 232 may be formed of microcrystalline silicon or amorphous silicon which includes a first conductive type impurity. The third lower layer 232 may have a thickness of 5 to 40 nm (e.g., 10 to 30 nm).

The third intrinsic layer 234 has a higher band gap than that of each of the first photoelectric conversion unit 100 and the first and second intrinsic layers 214 and 224. For example, the third intrinsic layer 234 may have a band gap of 1.6 eV to 1.9 eV (e.g., 1.6 eV to 1.8 eV). To suit the band gap, the third intrinsic layer 234 may be formed of updoped amorphous silicon. The third intrinsic layer 234 may have a thickness T3 of 50 nm to 300 nm (e.g., 100 nm to 250 nm).

The third upper layer 236 may be formed of amorphous silicon including a second conductive type impurity. In this regard, the amorphous silicon of the third upper layer 236 may include carbon or oxygen. The third upper layer 236 may have a thickness of 5 to 30 nm (e.g., 10 to 20 nm).

As described above, in the present embodiment, due to inclusion of the second photoelectric conversion unit 200 including the first, second and third conversion portions 210, 220 and 230 and the first photoelectric conversion unit 100, a larger number of wavelengths of light may be used and current densities of these elements may be more balanced.

FIG. 8 is a partial sectional view of a solar cell according to another embodiment of the present invention. FIG. 9 is a partial sectional view of a solar cell according to another embodiment of the present invention.

In the above-described embodiments, the back surface field layer 116 is entirely formed at the semiconductor substrate 110 and the second electrodes 420 have patterns. However, the disclosure is not limited to the above examples.

For example, as illustrated in FIG. 8, the back surface field layer 116 may be formed to have an overall uniform thickness and a uniform doping concentration, and the second electrode 420 may be entirely formed on the back surface of the semiconductor substrate 110. Accordingly, light is reflected by the second electrode 420 and thus, light utilization may be increased. The second electrode 420 may be formed using various methods such as plating, deposition, printing, or the like.

Alternatively, as illustrated in FIG. 9, an insulating film (e.g., a passivation film 118) may be formed on the back surface of the semiconductor substrate 110, and the second electrode 420 may be entirely formed on the passivation film 118 while in point contact with the semiconductor substrate 110 (or the back surface field layer 116).

That is, the second electrode 420 may include first portions 420a formed through the passivation film 118 to be in point contact with the back surface field layer 116 of the semiconductor substrate 110 and a second portion 420b that is connected to the first portions 420a and is entirely formed on the passivation film 118. Accordingly, the second electrode 420 may be electrically connected to the back surface field layer 116 by the first portions 420a and passivation properties may be improved by portions of the passivation film 118 except for portions in which the first portions 420a are formed. In addition, back reflection may be increased by the second portion 420b entirely formed on the passivation film 118 and thus, light utilization may be increased.

The second electrode 420 and the back surface field layer 116 that have the above-described structures may be formed by, for example, laser firing contact. That is, a layer for the second electrode 420 is entirely formed on the passivation film 118 by plating, deposition, screenprinting, or the like. In addition, when portions in which the first portions 420a are to be formed are locally irradiated with laser beams, the semiconductor substrate 110, the passivation film 118, and the layer for the second electrode 420 are correspondingly melted and mixed to form the first portions 420a. In this regard, the kind, wavelength, intensity, and the like of a laser may be varied according to the materials, thicknesses and the like of the passivation film 118 and the second electrode 420. However, the disclosure is not limited to the above examples, and the solar cell having the above-described structure may be manufactured using various other methods.

Particular features, structures, or characteristics described in connection with the embodiment are included in at least one embodiment of the present disclosure and not necessarily in all embodiments. Furthermore, the particular features, structures, or characteristics of any specific embodiment of the present disclosure may be combined in any suitable manner with one or more other embodiments or may be changed by those skilled in the art to which the embodiments pertain. Therefore, it is to be understood that contents associated with such combination or change fall within the spirit and scope of the present disclosure.

Although embodiments have been described with reference to a number of illustrative embodiments thereof, it should be understood that numerous other modifications and applications may be devised by those skilled in the art that will fall within the intrinsic aspects of the embodiments. More particularly, various variations and modifications are possible in concrete constituent elements of the embodiments. In addition, it is to be understood that differences relevant to the variations and modifications fall within the spirit and scope of the present disclosure defined in the appended claims.

## Claims

1. A solar cell comprising:
a first photoelectric conversion unit based on crystalline semiconductor;
a second photoelectric conversion unit on the first photoelectric conversion unit and comprising a plurality of conversion portions based on amorphous semiconductor;
a bonding layer disposed between the first and second photoelectric conversion units to connect the first photoelectric conversion unit to the second photoelectric conversion unit; and
electrodes electrically connected respectively to the first and second photoelectric conversion units.

2. The solar cell according to claim 1, wherein the bonding layer has a structure in which micro-crystalline semiconductors are included in an amorphous matrix.

3. The solar cell according to claim 1, wherein:
the first photoelectric conversion unit comprises a base region having a first conductive type and an emitter layer having a second conductive type that is different to the first conductive type; and
the bonding layer is on the emitter layer and has the first conductive type.

4. The solar cell according to claim 1, wherein the bonding layer has an index of refraction of 1.6 to 1.9.

5. The solar cell according to claim 1, wherein the first photoelectric conversion unit comprises monocrystalline or polycrystalline silicon and has a band gap of 1.0 eV to 1.2 eV.

6. The solar cell according to claim 1, wherein the conversion portions of the second photoelectric conversion unit has a higher band gap than that of the first photoelectric conversion unit and the band gap of the conversion portions of the second photoelectric conversion unit increases with a distance away from the first photoelectric conversion unit.

7. The solar cell according to claim 1, wherein a ratio of current densities of the conversion portions to the first photoelectric conversion unit is 0.8:1 to 1.2:1.

8. The solar cell according to claim 1, wherein the conversion portions comprise a first conversion portion on the first photoelectric conversion unit and having a first band gap and a second conversion portion on the first conversion portion and having a second band gap that is higher than the first band gap.

9. The solar cell according to claim 8, wherein:
the first conversion portion comprises a first intrinsic layer comprising an amorphous silicon layer comprising germanium; and
the second conversion portion comprises a second intrinsic layer comprising an undoped amorphous silicon layer.

10. The solar cell according to claim 9, wherein:
the first band gap is between 1.2 eV and 1.6 eV;
the second band gap is between 1.6 eV and 1.9 eV;
the first intrinsic layer has a thickness of 100 nm to 350 nm; and
the second intrinsic layer has a thickness of 50 nm to 300 nm.

11. The solar cell according to claim 8, wherein the conversion portions further comprise a third conversion portion on the second conversion portion and having a third band gap that is higher than the second band gap.

12. The solar cell according to claim 11, wherein:
the first conversion portion comprises a first intrinsic layer comprising an amorphous silicon layer comprising germanium;
the second conversion portion comprises a second intrinsic layer comprising an amorphous silicon layer containing a smaller amount of germanium than that contained in the first intrinsic layer; and
the third conversion portion comprises a third intrinsic layer comprising an undoped amorphous silicon layer.

13. The solar cell according to claim 12, wherein:
the first band gap is between 1.2 eV and 1.45 eV;
the second band gap is between 1.4 eV and 1.6 eV;
the third band gap is between 1.6 eV and 1.9 eV;
the first intrinsic layer has a thickness of 100 nm to 350 nm;
the second intrinsic layer has a thickness of 50 nm to 300 nm; and
the third intrinsic layer has a thickness of 50 nm to 300 nm.

14. The solar cell according to claim 1, wherein the electrodes comprise a first electrode electrically connected to the second photoelectric conversion unit and a second electrode electrically connected to the first photoelectric conversion unit, the first electrode comprising a transparent electrode layer on the second photoelectric conversion unit and a metal electrode on the transparent electrode layer.

15. A method of manufacturing a solar cell, the method comprising:
forming a first photoelectric conversion unit by forming an emitter layer through doping of a semiconductor substrate comprising crystalline semiconductor with an impurity;
forming a bonding layer on the emitter layer;
forming a second photoelectric conversion unit comprising amorphous semiconductor on the bonding layer; and
forming a first electrode electrically connected to the second photoelectric conversion unit and a second electrode electrically connected to the semiconductor substrate,
wherein the forming of the second photoelectric conversion unit comprises: forming a first conversion portion on the bonding layer, the first conversion portion having a first band gap that is higher than that of the semiconductor substrate; and forming a second conversion portion on the first conversion portion, the second conversion portion having a second band gap that is higher than the first band gap.
